# EUROPÄISCHE PATENTSCHRIFT

(11) **EP 1 081 093 B1**
(45) Veröffentlichungstag und Bekanntmachung des Hinweises auf die Patenterteilung: **04.10.2006**
(21) Anmeldenummer: 00115385.7
(22) Anmeldetag: 15.07.2000
(51) Int. Cl.: B81B 3/00, H01L 21/306, H01L 29/84

(54) **Verfahren zur Herstellung oberflächenmikromechanischer Strukturen durch Ätzung mit einem dampfförmigen, flusssäurehaltigen Ätzmedium**
Process for the fabricaiton of micromechanical shallow structures by etching with a vapour phase medium containing hydrofluoric acid
Procédé de fabrication de structures micromécaniques superficielles par gravure avec un agent en phase vapeur contenant de l'acide fluorhydrique

(30) Priorität: 28.08.1999 DE 19941042
(43) Veröffentlichungstag der Anmeldung: 07.03.2001
(73) Patentinhaber: ROBERT BOSCH GMBH, 70442 Stuttgart (DE)
(72) Erfinder: Laermer, Franz, 70437 Stuttgart (DE); Schilp, Andrea, 73525 Schwaebisch Gmuend (DE)

(56) Entgegenhaltungen:
- EP-A- 0 746 016
- WO-A-94/28426
- DE-A- 19 704 454
- WATANABE H ET AL: "INFLUENCE OF WATER ADSORPTION/DESORPTION PROCESSES ON THE SELECTIVITY OF VAPOR HF ETCHING" JOURNAL OF THE ELECTROCHEMICAL SOCIETY, ELECTROCHEMICAL SOCIETY. MANCHESTER, NEW HAMPSHIRE, US, Bd. 142, Nr. 4, April 1995 (1995-04), Seiten 1332-1340, XP001069252 ISSN: 0013-4651
- ANGUITA J ET AL: "HF/H2O vapor etching of SiO2 sacrificial layer for large-area surface-micromachined membranes" SENSORS AND ACTUATORS A, ELSEVIER SEQUOIA S.A., LAUSANNE, CH, Bd. 64, Nr. 3, 31. Januar 1998 (1998-01-31), Seiten 247-251, XP004116352 ISSN: 0924-4247

## Beschreibung

Die Erfindung betrifft ein Verfahren zur Herstellung oberflächenmikromechnischer Strukturen durch Ätzung einer Opferschicht mit einem dampfförmigen, flußsäurehaltigen Ätzmedium, nach der Gattung des Hauptanspruches.

### Stand der Technik

In der Silizium-Oberflächenmikromechanik ist bekannt, auf einer Substratoberfläche, üblicherweise einem Siliziumwafer, einen Schichtaufbau zu erzeugen, der aus einer Opferschicht, aus SiO₂ und einer darüber befindlichen Lage von aktivem Silizium, meist Polysilizium oder einkristallinem Silizium ("Silicon on Insulator" (SOI)), besteht. Mit diesem Schichtaufbau werden dann im weiteren durch Strukturierung der Oberfläche und selektive Ätzung der Opferschicht freitragende Strukturen erzeugt.

Zur Entfernung der Siliziumdioxidopferschicht unter oberflächenmikromechanischen Strukturen bedient man sich in der Sensorfertigung beispielsweise des in DE 197 04 454. vorgeschlagenen Dampfätzverfahrens in dampfförmiger, azeotroper Flußsäure. Dazu wird eine wäßrige, azeotrope Flußsäurelösung beispielsweise durch einen Heißwassermantel erhitzt, und auf eine Temperatur von beispielsweise 50°C gebracht. Weiter wird mit einem Deckel der Ätzvorrichtung, der gleichzeitig den zu prozessierenden Wafer trägt, das die Flußsäurelösung und die darüber erzeugte, damit im Gleichgewicht stehende Dampfphase enthaltende Gefäß abgeschlossen, so daß der Wafer der Einwirkung des feuchten Flußsäuredampfes ausgesetzt ist. Die Wafertemperatur wird weiter über eine geeignete Deckelheizung exakt kontrolliert und beispielsweise auf 70°C stabilisiert. Durch den eingesetzten HF-Dampf wird als Opferschicht aufgebrachtes SiO₂ zu flüchtigen Siliziumfluoriden umgewandelt und dadurch unter den freizulegenden Strukturen herausgelöst.

SiO₂ + 2 H₂O + 4 HF → SiF₄ + 4 H₂O

Damit die genannte Reaktion ablaufen kann ist offensichtlich die Anwesenheit von Wasser erforderlich. Aus der Reaktionsgleichung geht weiter hervor, daß bei der Reaktion mehr Wasser gebildet als eingesetzt wird.

Weiter ist bereits bekannt, daß zur Einstellung der Ätzrate des unter aktiven Sensorstrukturen zu entfernenden Siliziumdioxids vor allem die Temperaturdifferenz zwischen der Flußsäurelösung und der Waferoberfläche entscheidend ist. Eine zu geringe oder zu große Temperaturdifferenz führt zu einer deutlichen Verringerung der Ätzraten von beispielsweise 30%/K Temperaturdifferenzänderung.

In der DE 198 50 078 ist dazu in Weiterführung der DE 197 04 454 vorgeschlagen worden, die Temperaturdifferenz zwischen der Flußsäurelösung und der Wafertemperatur zu stabilisieren, und andererseits die Deckelheizung mit einer Vielzahl von Heizzonen auszustatten, so daß darüber dem Deckel ein Temperaturprofil eingeprägt werden kann. Somit wird es möglich, ein weitgehend frei wählbares Temperaturprofil über den Deckel und damit über den zu prozessierenden Wafer einzustellen, womit Einzelheiten der Wafer, insbesondere hinsichtlich lokal unterschiedlicher Ätzgeschwindigkeiten, ausgeglichen werden können. Außerdem ist aus der DE 198 50 078 bereits bekannt, Kondensationströpfchen in der Ätzvorrichtung durch geeignete Zusatzheizungen zu vermeiden, da durch Kondensation die Prozeßreproduzierbarkeit, unter anderem aufgrund einer Anreicherung von Fluorokieselsäure im Kondensat, leiden würde.

Schließlich wurde in der DE 199 10 983 vorgeschlagen, über eine Resonanzfrequenzänderung von auf dem Wafer zusätzlich angelegten LC-Resonatoren den Ätzfortschritt, d.h. den Fortgang der Unterätzung in der Siliziumdioxidopferschicht unter den LC-Resonatoren und darüber unter den freizulegenden aktiven Strukturen zu überwachen und zu messen. Damit ist es in einfacher Weise möglich, den Fortgang des Ätzprozesses und das Erreichen des gewünschten Ätzfortschrittes d.h. den "Endpunkt" des Ätzprozesses zu bestimmen.

### Vorteile der Erfindung

Das erfindungsgemäße Verfahren mit den kennzeichnenden Merkmalen des Hauptanspruches hat gegenüber dem Stand der Technik den Vorteil, daß damit beim lateralen Unterätzen in der Opferschicht verbleibende Opferschichtreste zumindest sehr weitgehend oder vollständig entfernt werden können. Dies ist mit bekannten Verfahren nicht möglich.

Da solche Opferschichtreste aus Siliziumdioxid stellenweise nahezu die Höhe des Ätzspaltes d.h. der Dicke der Opferschicht erreichen können, können sie das mechanische Verhalten der freigelegten aktiven Strukturen schädlich beeinflussen, indem sie deren Bewegungen, beispielsweise nach unten auf das Substrat hin oder zur Seite, blockieren oder zumindest bremsen bzw. behindern. Das erfindungsgemäße Verfahren bietet somit die Möglichkeit, die Qualität, Lebensdauer und Ausschußrate bei der Produktion der erzeugten aktiven Strukturen wesentlich zu verbessern.

Außerdem haben solche unerwünschten, bisher weitgehend nicht vermeidbaren Opferschichtreste einen negativen Einfluß auf die Schwingungsgüte freistehender Strukturen. Insofern stellen sie auch in dieser Hinsicht ein Qualitätsrisiko für die so hergestellten Sensoren bzw. aktiven Strukturen dar.

Das erfindungsgemäße Verfahren ist gleichzeitig vorteilhaft sehr einfach und kostengünstig zu realisieren, ohne daß in beträchtlichem Umfang in bestehende Ätzprozesse oder Fertigungsverfahren eingegriffen werden muß.

Weitere vorteilhafte Weiterbildungen und Ausgestaltungen der Erfindung ergeben sich aus den in den Unteransprüchen genannten Maßnahmen.

So wird dadurch, daß gegen Ende des Ätzprozesses ein kontrollierter und möglichst schlagartig auftretender Ätzstopp vorgesehen ist, vorteilhaft eine Handling-Toleranz des Ätzprozesses erreicht, d.h. der Operator oder ein automatischer Handlingmechanismus muß den fertig prozessierten Wafer nicht auf die Sekunde genau aus der Ätzvorrichtung ausladen, um ein Überätzen zu vermeiden. Vielmehr kann der geätzte Wafer vorteilhaft, ohne daß er einer unerwünschte Überätzung ausgesetzt ist, nach dem Ätzstopp bei Bedarf zumindest kurzzeitig in der Ätzvorrichtung belassen werden.

Im übrigen ist ein kontrollierter und möglichst schlagartig auftretender Ätzstopp auch hinsichtlich der Unterdrückung von in der Halbleitertechnik gefürchteten "Staining-Effekten" vorteilhaft.

### Zeichnungen

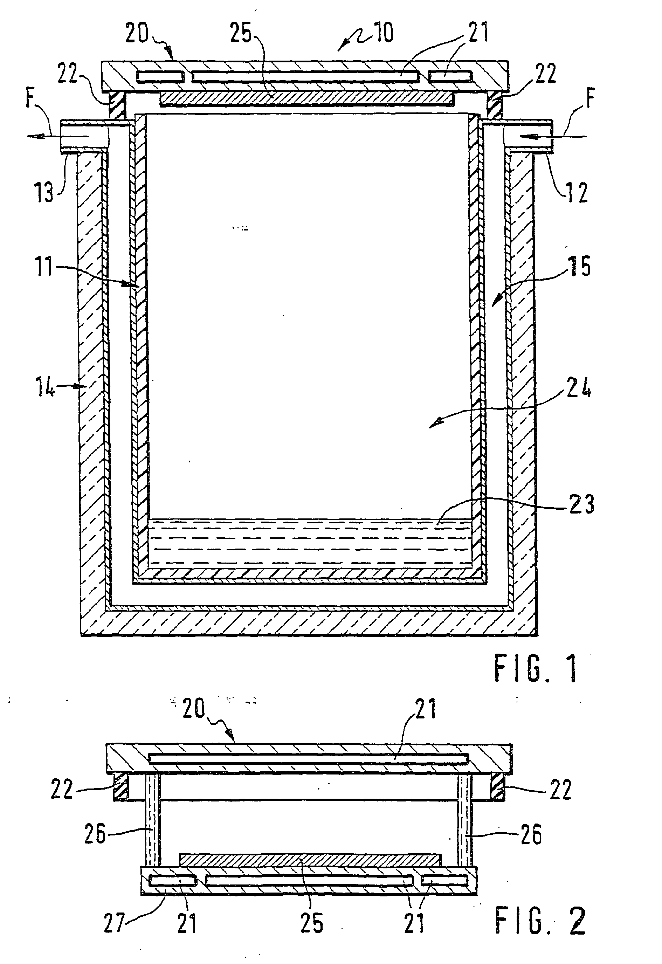

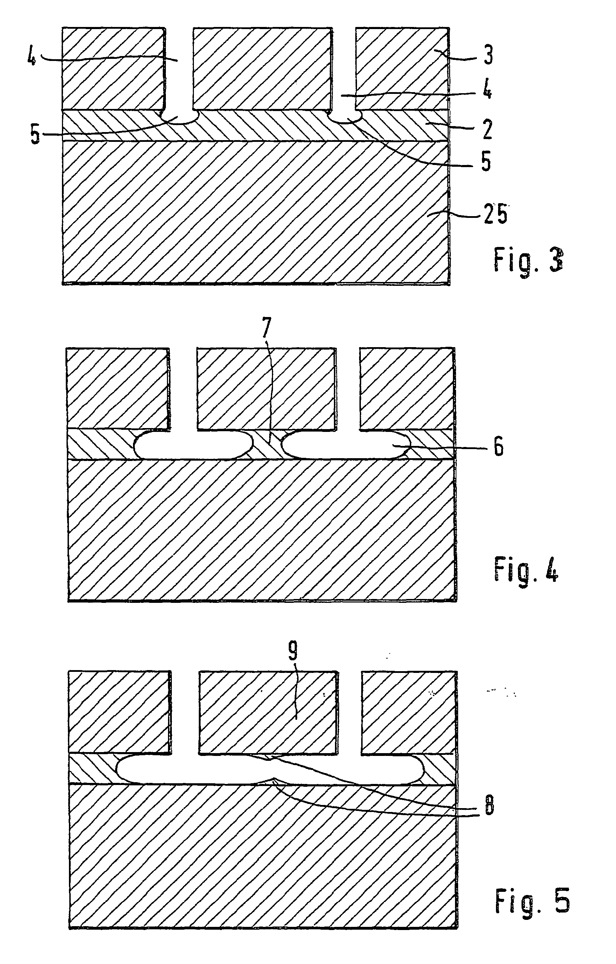

Die Erfindung wird anhand der Zeichnungen und in der nachfolgenden Beschreibung näher erläutert. Die Figur 1 zeigt einen Schnitt durch eine Ätzvorrichtung, die Figur 2 zeigt einen Ausschnitt aus Figur 1 mit modifizierter Ausführung des Deckels, und die Figuren 3 bis 5 erläutern zu fortschreitenden Zeiten das Entfernen der Opferschicht durch den Ätzprozeß.

### Ausführungsbeispiele

Die Figur 1 zeigt eine Ätzvorrichtung 10 mit einem Behälter 11, beispielsweise aus Teflon, der ein azeotropes Fluorwasserstoffsäure-Wassergemisch 23 enthält und in dem ein Siliziumwafer als Substrat 25 angeordnet ist. Der Behälter 11 ist vollständig umgeben von einem Heizmantel 15, durch den beispielsweise Wasser von wählbarer Temperatur von einem nicht dargestellten Thermostaten im Kreislauf gepumpt wird. Dadurch wird die Temperatur des Behälters 11 und des azeotropen Fluorwasserstoffsäure-Wassergemisches 23 auf einen gewünschten, definiert einstellbaren Wert stabilisiert. Natürlich ist an dieser Stelle jede andere Art von Heizung, beispielsweise elektrische Heizbänder, Heißluftgebläse, Heißwassermäntel, etc. statt des Heizmantels 15 denkbar. Wesentlich ist stets nur, daß die Wände des Behälters 11 und das Fluorwasserstoffsäure-Wassergemisch 23 gleichmäßig auf möglichst gleiche Temperatur gebracht werden, so daß eine Kondensation von Feuchtigkeit an den Wänden vermieden und eine besonders homogene Dampfphase als dampfförmiges, flußsäurehaltiges Ätzmedium 24 erzeugt wird.

Der Behälter 11 weist weiter einen Einlaß 12 und einen Auslaß 13 auf, durch den in Richtung des Pfeiles, der mit F gekennzeichnet ist, beispielsweise Wasser von wählbarer Temperatur geleitet werden kann. Der Behälter 11 und der Heizmantel 15 sind in einem Isolationsmantel 14 angebracht, so daß die Temperatur innerhalb des Behälters 11 konstant gehalten werden kann. Der Behälter 11 wird weiter von einem Deckel 20 abgeschlossen, der Dichtungen 22 aufweist, die beispielsweise aus Teflon oder Viton oder sonstigem Dichtungsmaterial gefertigt sind, welches resistent gegen Fluorwasserstoffsäuredampf ist. In diesem Deckel 20 ist eine Heizvorrichtung in Form eines Heizelementes 21 angebracht, so daß das auf der Innenseite des Deckels 20 angebrachte Siliziumsubstrat 25 beheizt und auf eine gewünschte Temperatur von beispielsweise 330 bis 373 Kelvin, vorzugsweise 343 K, gebracht werden kann. Die Heizvorrichtung kann alternativ auch ein Heißwasserkreislauf sein, oder man verwendet nicht dargestellte elektrische Heizfolien in Verbindung mit einem Thermoelement und einem elektronischen Temperaturregler.

Die Figur 2 zeigt eine weitere, bevorzugte Ausgestaltung des Deckels 20 der Ätzvorrichtung 10 zur Durchführung des Ätzprozesses. Dabei wird das Substrat 25 nicht wie in Figur 1 kopfüber gegen die Deckelinnenseite geklemmt, sondern auf eine untere beheizte Substratplatte 27 gelegt, die mit der Deckelinnenseite verbunden ist. Die Substratplatte 27 enthält weiter ebenfalls Heizelemente 21. Die Beheizung des Deckels 20 dient im übrigen auch der Vermeidung einer Kondensation von HF-Dampf.

Die Substratplatte 27 und die Deckelinnenseite sind weiter über mindestens zwei hohle Teflonstege 26 miteinander verbunden, in den elektrische Stromzuführungen sowie elektrische Verbindungen der Heizelemente 21 geführt sind. Eine definierte Einstellung der Temperatur der Substratplatte 27 erfolgt im übrigen in an sich bekannter Weise auf eine Temperatur von beispielsweise 330 bis 373 Kelvin, vorzugsweise 343 K, mittels einer nicht dargestellten Temperaturregelung analog der Einstellung der Temperatur des gesamten Deckels 20 gemäß Figur 1.

Als Fluorwasserstoffsäure-Wassergemisch 23 wird vorzugsweise ein azeotropes Gemisch gewählt, d.h. ein Gemisch mit einer HF-Konzentration von ungefähr 38 %. Bei einem azeotropen Gemisch wird Wasser und HF in einem konstant bleibenden Verhältnis aus dem Fluorwasserstoffsäure-Wassergemisch 23 verdampft, so daß dessen Konzentration über eine lange Zeit konstant bleibt. Infolgedessen bleibt die Fluorwasserstoffsäurekonzentration in dem Fluorwasserstoffsäure-Wassergemisch 23 auch bei schwindender Menge des Gemisches unverändert und es liegen stets konstante Dampfätzbedingungen für viele zu behandelnde Substrate 25 vor.

Hinsichtlich weiterer, an sich bekannter Details der Ätzvorrichtung 10 und des damit durch geführten Ätzprozesses sei auf die DE 197 04 454 verwiesen.

Die Figuren 3 bis 5 erläutern vereinfacht das Fortschreiten des Dampfätzprozesses unter einer auf dem Substrat 25 freizulegenden, aktiven, oberflächenmikromechanischen Struktur 9. Weitere detaillierte Erläuterungen dazu sind der DE 195 37 814 zu entnehmen.

Das Substrat 25 trägt zunächst eine SiO₂-Schicht oder eine im wesentlichen aus SiO₂ bestehende Schicht, die eine Dicke von 1 µm bis 4 µm hat, als sogenannte Opferschicht 2. Als SiO₂-Schicht kann beispielsweise ein thermisches Oxid, TEOS (Tetraethylorthosilikat) oder LTO ("Low Temperature Oxid") verwendet werden. Über der Opferschicht 2 befindet sich dann eine dicke Polysiliziumschicht, sogenanntes Epipolysilizium, als zweite Schicht 3, in die Trenchgräben 4 eingeätzt sind, welche auf der Opferschicht 2 stoppen. In der Opferschicht 2 ist weiter im Bereich der Trenchgräben 4 eine beginnende isotrope Opferschichtätzung angedeutet, die zur Ausbildung von Mulden 5 führt, und zunächst von diesen Mulden 5 ausgehend stabil fortschreitet.

Die Figur 4 zeigt, wie sich beim weiteren Fortschreiten des Ätzprozesses isotrope Ätzfronten 6 in der Opferschicht 2 bilden und sich aufeinanderzubewegen, wobei mit zunehmendem Ätzfortschritt zwischen den Ätzfronten 6 verbliebene Restbereiche 7 immer dünner werden. Mit der wachsenden lateralen Ausdehnung der Unterätzung steigt gleichzeitig die Wegstrecke für den Transport von Ätzspezies aus dem dampfförmigen Ätzmedium 24 zum Ort der Ätzreaktion hin oder vom Ort der Ätzreaktion weg an.

Figur 5 zeigt dann den Zeitpunkt des Zusammentreffens der Ätzfronten 6 und damit des Freilegens einer frei beweglichen Struktur 9, die beispielsweise als aktive Sensorstruktur eingesetzt werden kann. In Figur 5 sind weiter dabei vielfach entstehende Opferschichtreste 8 angedeutet, die mit bekannten Ätzverfahren nur sehr schwierig bis gar nicht zu verhindern oder zu entfernen sind.

Ein wesentliches Ziel der Erfindung ist daher die zumindest weitgehende oder vollständige Entfernung bzw. Vermeidung der Bildung dieser Opferschichtreste 8 durch Modifikation des bekannten Ätzverfahrens.

In einem ersten Ausführungsbeispiel des erfindungsgemäßen Verfahrens ist daher zur Vermeidung derartiger Opferschichtreste 8, die zumindest weitgehend aus Siliziumdioxid bestehen, vorgesehen, mit fortschreitender Ätzreaktion kontinuierlich oder in diskreten Stufen die relative Feuchtigkeit in dem Ätzmedium 24 dem Ätzfortschritt anzupassen. Mit der Anpassung der relativen Feuchtigkeit des Ätzmediums an das Ausmaß der im Laufe des Ätzprozesses bereits erreichten Unterätzung wird dabei vielfach gleichzeitig auch der HF-Gehalt des dampfförmigen Ätzmediums 24 verändert.

Unter relativer Feuchtigkeit ist dabei im Sinne der Erfindung stets die Feuchtigkeit in dem Ätzmedium 24 bezogen auf die jeweilige Temperatur der Waferoberfläche, d.h. die Feuchtigkeit des dampfförmigen Ätzmediums 24 relativ zur jeweiligen Temperatur des prozessierten Substrates 25 zu verstehen, wobei auch die Oberflächenbeschaffenheit des Substrates 25 einen geringen Einfluß haben kann. In diesem Sinne ist eine relative Feuchtigkeit bezogen auf die Oberfläche des Substrates 25 von 100 % beispielsweise darin erreicht, wenn bei einer gegebenen Temperatur des Substrates 25 eine weitere Erhöhung der Feuchtigkeit in dem Ätzmedium 24 zu einer Kondensation des dampfförmigen Ätzmediums 24 auf dem Substrat 25 führt.

Somit ist der Begriff "relative Feuchtigkeit" weitgehend analog dem bekannten Begriff der "relativen Luftfeuchtigkeit" zu verstehen als das Verhältnis der in einem Gasvolumen V im Ätzmedium 24 bei einer Wafertemperatur T enthaltenen Wassermenge zu der maximal in dieses Gasvolumen V bei der Wafertemperatur T ohne Kondensation auf der Substratoberfläche einbringbare Wassermenge.

Im einzelnen wird im erläuterten Beispiel mit zunehmendem Ätzfortschritt im Sinne dieses Begriffes von relativer Feuchtigkeit, der Wassergehalt des Ätzmediums 24 kontinuierlich oder in diskreten Stufen erhöht. Dies kann dadurch erreicht werden, daß die Temperatur des Fluorwasserstoffsäure-Wassergemisches 23 bei konstanter Deckeltemperatur oder die Temperatur des Deckels 20 bzw. des Substrates 25 bei konstanter Temperatur des Fluorwasserstoffsäure-Wassergemisches 23 verändert wird. Bevorzugt erfolgt diese Veränderung so, daß die Temperatur des Fluorwasserstoffsäure-Wassergemisches 23 bei konstanter Deckeltemperatur oder Wafertemperatur kontinuierlich oder in diskreten Schritten erhöht oder die Deckeltemperatur bzw. die Wafertemperatur bei konstanter Temperatur des Fluorwasserstoffsäure-Wassergemisches 23 kontinuierlich oder in diskreten Schritten erniedrigt wird.

Aufgrund der großen thermischen Trägheit des Fluorwasserstoffsäure-Wassergemisches 23 und der sehr geringen thermischen Trägheit des Systems Deckelheizung-Deckel-Wafer ist die Variation, insbesondere Erniedrigung, der Deckel- bzw. Wafertemperatur bevorzugt, weil diese nahezu instantan erfolgt kann und regelungstechnisch unproblematisch ist.

Der Erfolg der Anpassung der relativen Feuchtigkeit in dem Ätzmedium 24 mit fortschreitender Ätzreaktion oder lateraler Unterätzung mit dem Ziel der Vermeidung der Ausbildung von Opferschichtresten 8 unter den zu unterätzenden Strukturen 9, um somit beispielsweise deren freie Beweglichkeit jederzeit gewährleisten zu können, beruht dabei auf folgendem Wirkmechanismus:
Während der Opferschichtätzung wird bekanntermaßen Wasser benötigt, um die Ätzreaktion des SiO₂ in Gang zu setzen:

SiO₂ + 2 H₂O → Si (OH)₄ (bzw. SiO₂ * 2 H₂O)

Si(OH)₄ + 4 HF → SiF₄ + 4H₂O

SiF₄ + 2 HF → H₂SiF₆

Dabei ist das entstehende Siliziumtetrafluorid (SiF₄) gasförmig oder in wäßriger Lösung gebunden. Die entstehende Fluorokieselsäure (H₂SiF₆) liegt ebenfalls in der Regel in wäßriger Lösung vor. Nach dem Start der Ätzreaktion zur lateralen Unterätzung wird also zunächst mehr Wasser freigesetzt, als zur Initiierung der Ätzreaktion nötig war und zur Aufrechterhaltung der weiteren Ätzreaktion nötig ist.

Aus diesem Grund muß die Ätzreaktion auf dem Substrat 25 bei einer gegenüber dem dampfförmigen Ätzmedium 24 erhöhten Temperatur stattfinden, da ansonsten eine Akkumulation von Reaktionswasser auf der SiO₂-Oberfläche d.h. im Bereich der Opferschicht 2 auftritt, was durch Tröpfchenbildung letztlich stellenweise zum irreversiblen Verkleben der freigeätzten Strukturen 9 mit dem Substrat 25 und somit zu dessen Unbrauchbarkeit führen würde. Das Ätzmedium 24 steht im übrigen in der Regel im thermischen Gleichgewicht mit dem Fluorwasserstoffsäure-Wassergemisch 23 Weiter wirkt das überschüssige Reaktionswasser zusätzlich im Sinne einer Rückkopplung weiter ätzratensteigernd, wenn man dieser Akkumulation nicht durch die Wafertemperatur entgegenwirkt.

Durch die erhöhte Temperatur des Substrates 25 bzw. des Deckels 20 gegenüber dem Ätzmedium 24 wird daher das entstehende Reaktionswasser zumindest teilweise abgedampft bzw. einer Kondensation von zusätzlichem Wasser aus dem Ätzmedium 24 entgegengewirkt, so daß sich ein Gleichgewichtszustand mit einem stationären Wasserfilm auf SiO₂-Oberflächen in der Opferschicht 2 einstellt. Damit wird der Ätzprozeß nach einer Anlaufphase, innerhalb der sich die Bedingungen dieses dynamischen Gleichgewichts einstellen, annähernd stationär.

Dieses Stadium des Ätzprozesses, das zunächst noch unproblematisch ist, entspricht der Darstellung in Figur 3.

Mit fortschreitender lateraler Unterätzung gemäß Figur 4 tritt dann eine Abmagerung der Menge an reaktiven Ätzspezies, insbesondere von zugeführtem Wasserdampf aus dem Ätzmedium 24, an den Ätzfronten 6 auf. Dabei ist zu berücksichtigen, daß der Dampfätzprozeß zunächst in an sich bekannter Weise so eingestellt worden war, daß er im Bereich der Ätzfronten 6 unter Berücksichtigung aller relevanter Faktoren, d.h. der Bildungsrate von Reaktionswasser, des Eintrags von Wassermolekülen aus dem dampfförmigen Ätzmedium 24, und des Abdampfens von Wasser von Oberflächen im Sinne eines dynamischen Gleichgewichts stationär geworden ist. Durch die allmähliche Reduktion der den Ätzfronten 6 zugeführten Wassermenge aus dem Ätzmedium 24 aufgrund des Transports über wachsende Unterätzweiten wird daher zunehmend derjenige Anteil dieses dynamischen Gleichgewichts verändert, der auf dem Eintrag von Wasserdampf aus dem Ätzmedium 24 beruht.

Die Abnahme der Wassermenge an den Ätzfronten 6 kommt insbesondere auch dadurch zustande, daß Wasserdampf bereits auf dem immer längeren Weg zur eigentlichen Ätzfront 6 an umgebenden Oberflächen kondensiert und nachfolgend wieder abgedampft wird. Somit wird zwar immer noch Reaktionswasser an den Ätzfronten 6 durch die Ätzreaktion produziert, die Summe des Wassereintrags in die Ätzreaktion an den Ätzfronten 6 nimmt jedoch insgesamt durch Verschiebung des dynamischen Gleichgewichtes ab.

Infolgedessen "magert" der Ätzprozeß zunehmend an Wasser ab und die Ätzraten sinken mit wachsender Unterätzweite. Da weiterhin mit abnehmender Ätzrate in der Opferschicht 2, d.h. abnehmender Auflösungsgeschwindigkeit von SiO₂, auch die Menge an pro Zeiteinheit gebildetem Reaktionswasser abnimmt, tritt zudem eine Selbstverstärkung Abnahme der Ätzrate ein, so daß sich das erläuterte Gleichgewicht neu auf einem deutlich niedrigeren Niveau mit deutlich niedrigerer Ätzrate einstellt.

Diese Abnahme der Unterätzgeschwindigkeit führt in der Praxis beim Unterätzen von nur über hohe Aspektverhältnisse zugänglichen Strukturen, beispielsweise Kammstrukturen oder perforierten Massen, verglichen mit frei zugänglichen Strukturen vielfach zu Unterschieden in den Ätzgeschwindigkeit von typischerweise 1:3 bis 1:4. Diese Unterschiede sind zwar sehr unerwünscht, jedoch meist noch tolerierbar.

Kritisch wird die Situation jedoch dann, wenn gegen Ende des Ätzprozesses, wie in Figur 5 dargestellt, nach dem Zusammenlaufen der Ätzfronten 6 nur noch Opferschichtreste 8 aus Siliziumoxid verblieben, und die zu ätzende Opferschichtfläche erheblich abgenommen hat. In diesem Stadium kommt die Ätzreaktion für diese Opferschichtreste 8 infolge Wassermangels zumindest nahezu zum Erliegen.

Gleichzeitig tritt ein weiterer, sehr unerwünschter Effekt auf, der auch nicht dadurch zu überwinden ist, daß man in dem in Figur 5 dargestellten Stadium des Ätzprozesses über lange Zeiten zusätzlich überätzt: Bei der Abnahme der an der Ätzfront 6 erzeugten Wassermenge im Endstadium des Ätzprozesses steigt unvermeidlich auch die Konzentration des aus der Auflösungsreaktion entstandenen, in dem Reaktionswasser gelösten Endprodukt H₂SiF₆ (Fluorokieselsäure).

Dieser "wassermangel" führt schließlich zu einem Eintrocknen dieser Flußsäurelösung und zur Bildung von sogenannten "Stains", d.h. einem selbst mit äußerst aggressiven Chemikalien nicht mehr ätzbarem, unlöslichen Siliziumoxid, das an die noch vorhandenen, an sich ätzbaren Siliziumoxidoberflächen gebunden ist und diese überdies passiviert.

In der Halbleitertechnik in diesem Zusammenhang üblicherweise bei Naßätzverfahren eingesetzte prozeßtechnische Maßnahmen, beispielsweise geeignete Ätzadditive, zur Unterdrückung dieses gefürchteten "Staining"-Effekts, sind beim erläuterten Ätzprozeß mit einem dampfförmigen Ätzmedium 24 nicht einsetzbar.

Die Bildung von "Stains" beruht dabei im wesentlichen auf der folgenden, beim Konzentrieren von gelöster Fluorokieselsäure auftretenden Rückreaktion mit verbliebenen Wassermolekülen:

n* H₂SiF₆ + 2n H₂O → [SiO₂]ₙ + 6n HF

Daher sieht das erläuterte Ausführungsbeispiel vor, daß zumindest nach dem Zusammenlaufen der Ätzfronten 6 ein Abmagern des Ätzprozesses an Feuchtigkeit bzw. Wasser mit zunehmender Unterätzweite so lange vermieden wird, solange sich noch in nennenswertem Umfang an sich ätzbare Opferschichtreste 8 auf dem Substrat 25 befinden.

Zur Erhöhung der relativen Feuchtigkeit in dem Ätzmedium 24, d.h. in der Dampfätzatmosphäre, steht eine große Vielzahl von Möglichkeiten bzw. Parametern bereit, die alternativ eingesetzt oder auch problemlos miteinander kombiniert werden können.

So kann durch Absenkung der Deckel- und damit der Wafertemperatur während des Fortschreitens des Ätzprozesses einer Abnahme der Wasserzufuhr zu den Ätzfronten 6 durch eine Steigerung des relativen Wassergehalts des Ätzmediums 24, bezogen auf das Substrat 25, entgegengewirkt werden. Dazu ist beispielsweise vorgesehen, nach dem Zusammenlaufen der Ätzfronten 6 durch ein finales Absenken der Deckel- und damit Wafertemperatur um beispielsweise 20 K, die Entfernung der letzten unter den freizulegenden Strukturen 9 befindlichen, an sich ätzbaren Opferschichtreste 8 zu gewährleisten.

Ein zweites Ausführungsbeispiel der Erfindung sieht in Weiterführung des ersten Ausführungsbeispiels vor, zusätzlich nach Abschluß des Ätzprozesses d.h. nach dem Entfernen der Opferschichtreste 8, den Ätzprozeß kontrolliert zu stoppen, um eine unerwünschte Unterätzung insbesondere gut zugänglicher und daher ohnehin schnell ätzender Bereiche zu vermeiden.

Dieser bevorzugt möglichst schnell oder schlagartig eingeleitete Ätzstopp wird dadurch erreicht, daß Feuchtigkeit in dem dampfförmigen Ätzmedium 24 nach dem Entfernen letzter Opferschichtreste 8 schlagartig erniedrigt wird. Dazu wird bevorzugt aufgrund der geringen thermischen Trägkeit die Wafertemperatur über die Temperatur des Deckels 20, d.h. durch eine geeignete, an sich bekannte Steuerung der Heizelemente 21, beispielsweise um 10 bis 20 K erhöht, so daß die Ätzreaktion praktisch schlagartig stoppt.

Um den Ätzfortschritt d.h. die jeweils als Funktion der Zeit bereits erreichte laterale Unterätzung kontrollieren und messen zu können und darüber eine Anpassung, insbesondere Erhöhung der relativen Feuchtigkeit des Ätzmediums nur gegen Ende des Ätzprozesses, d.h. kurz vor dem Durchbruch des Restbereiches 7 vornehmen zu können, und/oder zum Erkennen des Zeitpunktes des Erreichens einer definiert eingestellten lateralen Unterätzung, d.h. einer vollständigen Entfernung von Opferschichtresten 8 unter den freizuätzenden Strukturen 9, ist in diesem Ausführungsbeispiel weiter vorgesehen, das in der DE 199 10 983 vorgeschlagene Verfahren und die dort beschriebene Vorrichtung einzusetzen.

Kurz zusammengefaßt werden dazu zur kontinuierlichen meßtechnischen Erfassung der lateralen Unterätzweite gemäß DE 199 10 983 LC-Resonatoren bereichsweise auf dem Substrat 25 aufgebracht, die gemeinsam mit den aktiven Strukturen 9 unterätzt werden, wobei sich ihre Resonanzfrequenz als Funktion der Unterätzung ändert. Durch Messung der Resonanzfrequenzen bzw. Resonanzfrequenzänderungen dieser LC-Resonatoren, die der lateralen Unterätzung proportional sind, erhält man somit wahlweise kontinuierlich oder stichpunktartig eine Rückmeldung über den Fortgang der Ätzreaktion auf der Waferoberfläche und den Zeitpunkt des Durchbruch des Restbereiches 7 zum Einleiten des Ätzstoppes.

Durch die über die LC-Resonatoren jederzeit meßbare, bereits erreichte Unterätzung ist es in einfacher Weise möglich, exakt auf die Bedürfnisse des Ätzprozesses auf dem Substrat 25 zu reagieren und zu jedem Zeitpunkt die benötigte Menge an relativer Feuchtigkeit in dem Ätzmedium 24 zur Verfügung zu stellen. Dazu wird beispielsweise aus dem gemessenen Ätzfortschritt eine Regelgröße gewonnen, die einer an sich bekannten Regeleinrichtung zugeführt wird. Diese Regeleinrichtung stellt dann die relative Feuchtigkeit in dem Ätzmedium 24 automatisch auf einen zu jedem Zeitpunkt der lateralen Unterätzung optimalen, zuvor in Vorversuchen empirisch ermittelten Wert ein, und bricht den Ätzvorgang beim Erreichen einer voreingestellten Unterätzweite automatisch in der erläuterten Weise ab.

Neben den vorstehend erläuterten Möglichkeiten zur Einstellung der relativen Feuchtigkeit in dem Ätzmedium 24 im Laufe einer fortschreitenden Unterätzung, d.h. insbesondere der Veränderung der Deckeltemperatur oder der Veränderung der Temperatur des Fluorwasserstoffsäure-Wassergemisches 23, gibt es eine Reihe von weiteren Parametern zu deren Einstellung, die im folgenden erläutert werden. Dabei ist zu betonen, daß die erläuterten Möglichkeiten zur Einstellung der relativen Feuchtigkeit in dem Ätzmedium 24 auch untereinander kombiniert werden können, so daß im konkreten Ätzprozeß eine große Vielzahl von Parametern bereitsteht, auf die im jeweiligen Einzelfall zurückgegriffen werden kann und die alternativ oder auch gemeinsam variiert werden können.

So ist es offensichtlich möglich, anstelle einer isolierten Veränderung der Temperatur des Fluorwasserstoffsäure-Wassergemisches 23 oder der Temperatur des Deckels 20 auch beide Temperaturen während des Ätzprozesses gemeinsam so zu variieren, daß sich eine gewünschte, sich als Funktion der Unterätzung verändernde Temperaturdifferenz zwischen Deckeltemperatur oder Wafertemperatur und Temperatur des Fluorwasserstoffsäure-Wassergemisches 23 einstellt. Bevorzugt wird dazu diese Temperaturdifferenz kontinuierlich oder schrittweise mit dem Ätzfortschritt erniedrigt.

Ein weiteres Ausführungsbeispiel sieht vor, daß dem Ätzmedium 24 Sauerstoff, Stickstoff, Argon oder ein anderes, hinsichtlich des jeweiligen Dampfätzprozesses inertes Gas mit Fortschreiten des Ätzprozesses mit veränderlichem Gasfluß zugesetzt wird. Dazu wird dieses inerte Gas mit kontinuierlich oder in diskreten Schritten verändertem Gasfluß in die Ätzvorrichtung 10 über einen geeigneten Gaseinlaß eingelassen und nach einer Durchmischung mit dem Ätzmedium 24 über einen Gasauslaß wieder aus der Ätzvorrichtung 10 abgeführt. Damit stellt sich insgesamt eine Verdünnung des Ätzmediums 24 ein, was zu einer Erniedrigung des Dampfdruckes und damit einer Erniedrigung der relativen Feuchtigkeit des Ätzmediums 24 führt.

Im einzelnen wird dazu während des Ätzprozesses zunächst das inerte Gas, beispielsweise Sauerstoff, mit einem vorgegebenen Ausgangsgasfluß zugeführt, der mit fortschreitender lateraler Unterätzung kontinuierlich oder in diskreten Schritten definiert verringern wird. Durch diese Maßnahme steigt dann allmählich die Sättigung des dampfförmigen Ätzmediums 24 und damit dessen relative Feuchtigkeit an.

Im übrigen kann anstelle eines Inertgases auch trockenes HF-Gas mit einem kontrollierten Gasfluß über den Gaseinlaß in die Ätzvorrichtung 10 zusätzlich eingeleitet werden, um darüber den HF-Gehalt des Ätzmediums 24 zu verändern, insbesondere zu erhöhen. Dazu wird beispielsweise während des Fortschreitens der lateralen Unterätzung die Menge an zusätzlich zugeführtem trockenen HF-Gas kontinuierlich oder in diskreten Schritten erhöht, so daß das Ätzmediums 24 zunehmend aggressiver wird und sich damit die Bildung von Reaktionswasser durch Steigerung der Oxidauflösungsreaktion ebenfalls erhöht.

Ein weiteres Ausführungsbeispiel sieht vor, ein kontrolliertes hinsichtlich des Gasflusses einstellbares Leck, beispielsweise über ein entsprechendes Ventil in der Wand des Behälters 11, vorzusehen. Dieses Leck gewährleistet eine Verbindung zwischen dem Ätzmedium 24 im Inneren der Ätzvorrichtung 10 und der äußeren Atmosphäre, so daß über das Leck mit einer einstellbaren Leckrate das Ätzmedium 24 in die äußere Atmosphäre, beispielsweise in einen Abzug für toxische Gase, entweichen kann. Dies führt dazu, daß das dampfförmige Ätzmedium 24 über dem Fluorwasserstoffsäure-Wassergemisch 23 nicht gesättigt ist, wobei durch Veränderung der Leckrate während des Fortschreitens des Ätzprozesses der Sättigungsgrad des dampfförmigen Ätzmediums 24 verändert, insbesondere kontinuierlich oder in diskreten Schritten erhöht werden kann.

Neben oder alternativ zu den vorgenannten Parametern zur Einstellung der relativen Feuchtigkeit in dem Ätzmedium 24 kann über den Gaseinlaß auch zusätzlich Wasserdampf in die Ätzvorrichtung 10 eingeleitet werden, und damit den Wassergehalt des Ätzmediums 24 zu beeinflussen. Bevorzugt wird dazu während des Fortschreitens des Ätzprozesses die Menge an dem Ätzmedium 24 zugeführten Wasserdampfs kontinuierlich oder in diskreten Schritten erhöht.

Alternativ zu der Einleitung von Wasserdampf über den Gaseinlaß kann weiter auch ein Verdampfer vorgesehen sein, der im Bereich des Fluorwasserstoffsäure-Wassergemisches 23 plaziert ist, und der von außen derart gesteuert wird, daß er in definierter Weise zusätzlich Flüssigkeit aus dem Fluorwasserstoffsäure-Wassergemisch 23 verdampft. Der Verdampfer ist dazu beispielsweise als kleines Teflongefäß mit einer elektrischen Widerstandsheizung ausgeführt, das mit dem Fluorwasserstoffsäure-Wassergemisch 23 in Verbindung steht. Während des Fortschreitens des Ätzprozesses wird der Verdampfer dann beispielsweise zu einem gewünschten Zeitpunkt aktiviert und die Menge an verdampfter Flüssigkeit pro Zeiteinheit durch Erhöhung der elektrischen Leistung schrittweise oder kontinuierlich gesteigert, um die Sättigung bzw. die relative Feuchtigkeit des dampfförmigen Ätzmediums 24 zu erhöhen.

Anstelle des Verdampfers kann im übrigen auch eine Einspritzvorrichtung, beispielsweise in Form einer Einspritzdüse vorgesehen sein, mit der mit fortschreitendem Ätzprozeß zusätzlich Wasser in Form eines sehr feinen Tröpfchennebels in das Ätzmedium 24 eingespritzt wird, so daß sich ebenfalls die relative Feuchtigkeit in dem Ätzmedium 24 erhöht. Das eingespritzte Wasser ist im übrigen bevorzugt derart vorgewärmt, daß seine Temperatur mindestens der Temperatur des Fluorwasserstoffsäure-Wassergemisches 23 entspricht oder höher ist. Damit wird gewährleistet, daß das eingespritzte Wasser vollständig in die Gasphase übertritt bzw. als Wasserdampf die relative Feuchtigkeit in dem Ätzmedium 24 einstellt.

Schließlich kann innerhalb der Ätzvorrichtung 10 auch ein Ultraschallgeber vorgesehen sein, der mittels Ultraschalleinstrahlung in das Fluorwasserstoffsäure-Wassergemisch 23 an dessen Oberfläche einen feinen Tröpfchennebel in die Dampfphase überführt, so daß darüber in kontrollierter Weise zusätzliche Feuchtigkeit als Funktion der Unterätzung in das dampfförmige Ätzmedium 24 eingetragen wird.

Ein weiteres Ausführungsbeispiel der Erfindung sieht schließlich vor, daß im Inneren der Ätzvorrichtung 10 ein an sich bekannter Kondensor vorgesehen ist, dessen Temperatur über eine Regelung von außerhalb der Ätzvorrichtung 10 eingestellt werden kann. Im einzelnen wird dazu die Temperatur des Kondensors zunächst so eingestellt, daß an seinen Oberflächen eine Kondensation aus dem dampfförmigen Ätzmedium 24 erfolgt und die auftretenden Kondensattröpfchen prozeßunschädlich gesammelt und in das Fluorwasserstoffsäure-Wassergemisch 23 zurückgeführt werden.

Falls die Temperatur des Kondensors gleich oder größer aLs die Temperatur des Fluorwasserstoffsäure-Wassergemisch 23 ist, tritt keine nennenswerte Kondensation auf, so daß dem Ätzmedium 24 keine Feuchtigkeit entzogen wird. Das Ätzmedium 24 bleibt somit gegenüber der Oberfläche des Fluorwasserstoffsäure-Wassergemisches 23 gesättigt. Wird dagegen die Temperatur des Kondensors unter die Temperatur des Fluorwasserstoffsäure-Wassergemisches 23 abgesenkt, wird der.Kondensor dem Ätzmedium 24 Feuchtigkeit entziehen.

Zur Veränderung der relativen Feuchtigkeit in dem Ätzmedium 24 wird daher während des Ätzprozesses die Temperatur des Kondensors von Temperaturen unterhalb der Temperatur des Fluorwasserstoffsäure-Wassergemisches 23 kommend schrittweise oder kontinuierlich an diese Temperatur herangeführt, so daß dem Ätzmedium 24 zunehmend weniger Feuchtigkeit entzogen wird. Insgesamt wird damit die Menge an pro Zeiteinheit gebildeten Kondensates während des Fortschreitens des Ätzprozesses d.h. der lateralen Unterätzung erniedrigt und der Sättigungsgrad des dampfförmigen Ätzmediums 24 somit erhöht.

Wie bereits ausgeführt ist es ohne weiteres möglich, die aufgeführten Alternativen zur Beeinflussung der relativen Feuchtigkeit des Ätzmediums 24 kombiniert oder alternativ einzusetzen.

Besonders wichtig ist auch, daß jede dieser Methoden bzw. auch Kombinationen dieser Methoden auch umgekehrt dazu eingesetzt werden können, um den Ätzprozeß nach Erreichen einer gewünschten lateralen Unterätzung innerhalb kurzer Zeit oder schlagartig zu stoppen. Dazu ist es lediglich notwendig, die relative Feuchtigkeit in dem Ätzmedium 24 jeweils deutlich zu verringern, wodurch der Ätzprozeß, wie bereits ausgeführt, zum Erliegen kommt.

### Bezugszeichenliste

- 2: Opferschicht
- 3: zweite Schicht
- 4: Trenchgraben
- 5: Mulde
- 6: Ätzfront
- 7: Restbereich
- 8: Opferschichtrest
- 9: Struktur

- 10: Ätzvorrichtung
- 11: Behälter
- 12: Einlaß
- 13: Auslaß
- 14: Isolationsmantel
- 15: Heizmantel

- 20: Deckel
- 21: Heizelement
- 22: Dichtung
- 23: Fluorwasserstoffsäure-Wassergemisch
- 24: Ätzmedium
- 25: Substrat
- 26: Teflonsteg
- 27: Substratplatte

## Patentansprüche

1. Verfahren zur Herstellung oberflächenmikromechanischer Strukturen, wobei auf ein beheizbares Substrat (25) eine Opferschicht (2) deponiert und strukturiert wird, die zumindest weitgehend oder bereichsweise aus Siliziumdioxid besteht, auf der Opferschicht (2) eine zweite Schicht (3) abgeschieden und strukturiert wird, und die Opferschicht (2) in einem Ätzprozeß durch ein dampfförmiges, flußsäurehaltiges Ätzmedium (24) entfernt wird, wodurch die oberflächenmikromechanischen Strukturen (9) freigelegt werden, **dadurch gekennzeichnet, daß** mit fortschreitendem Entfernen der Opferschicht (2) eine kontrollierte Erhöhung der relativen Feuchtigkeit in dem Ätzmedium (24) erfolgt, wobei Opferschichtreste (8) unter den Strukturen (9) zumindest weitgehend oder vollständig entfernt werden.

2. Verfahren nach Anspruch 1, **dadurch gekennzeichnet, daß** die Erhöhung der relativen Feuchtigkeit des Ätzmediums (24) unter Berücksichtigung der Temperatur oder der Temperatur und der Oberflächenbeschaffenheit des Substrates (25) erfolgt, wobei die Erhöhung der relativen Feuchtigkeit in dem Ätzmedium (24) mit einer Veränderung der Flußsäurekonzentration und einer Veränderung der relativen Feuchtigkeit in dem Ätzmedium (24) verbunden wird.

3. Verfahren nach Anspruch 1 oder 2, **dadurch gekennzeichnet, daß** die Erhöhung kontinuierlich erfolgt.

4. Verfahren nach Anspruch 1 oder 2, **dadurch gekennzeichnet, daß** die Erhöhung in diskreten Stufen erfolgt.

5. Verfahren nach Anspruch 1, **dadurch gekennzeichnet, daß** das Ätzmedium (24) zumindest zeitweise durch Verdampfen eines im wesentlichen azeotropen Fluorwasserstoffsäure-Wassergemisches erzeugt wird.

6. Verfahren nach Anspruch 1 oder 2, **dadurch gekennzeichnet, daß** dem Ätzmedium (24) ein im wesentlichen für den Ätzprozeß chemisch inertes Gas, insbesondere Stickstoff, Sauerstoff oder Argon, zugesetzt wird, wobei die Erhöhung der relativen Feuchtigkeit und/oder die Erhöhung der Flußsäurekonzentration in dem Ätzmedium (24) zumindest zeitweise durch eine kontinuierliche oder schrittweise Reduktion der Konzentration des chemisch inerten Gases in dem Ätzmedium (24) erfolgt.

7. Verfahren nach Anspruch 1 oder 2, **dadurch gekennzeichnet, daß** die Erhöhung der relativen Feuchtigkeit zumindest zeitweise durch eine kontinuierliche oder schrittweise Erniedrigung der Temperatur des Substrates (25) erfolgt.

8. Verfahren nach Anspruch 1 oder 2, **dadurch gekennzeichnet, daß** die Erhöhung der relativen Feuchtigkeit zumindest zeitweise durch eine kontinuierliche oder schrittweise Erhöhung der Temperatur des Fluorwasserstoffsäure-Wassergemisches (23) erfolgt.

9. Verfahren nach Anspruch 1 oder 2, **dadurch gekennzeichnet, daß** die Erhöhung der relativen Feuchtigkeit zumindest zeitweise durch eine kontinuierliche oder schrittweise Erniedrigung einer voreingestellten Temperaturdifferenz zwischen dem Substrat (25) und dem Fluorwasserstoffsäure-Wassergemisch (23) erfolgt.

10. Verfahren nach Anspruch 1 oder 2, **dadurch gekennzeichnet, daß** die Erhöhung der relativen Feuchtigkeit zumindest zeitweise durch eine kontrollierte Zugabe, insbesondere kontinuierliche oder in diskreten Schritten erfolgende Erhöhung der Zugabe, von trockenem HF-Gas zu dem Ätzmedium (24) erfolgt.

11. Verfahren nach Anspruch 1 oder 2, **dadurch gekennzeichnet, daß** die Erhöhung der relativen Feuchtigkeit zumindest zeitweise mittels einer Leckvorrichtung erfolgt, über die mit einer kontrollierbaren Leckrate ein Austreten eines Anteils des Ätzmediums (24) aus der Ätzvorrichtung (10) erfolgt, wobei zumindest zeitweise über die Leckrate die relative Feuchtigkeit des dampfförmigen, flußsäurehaltigen Ätzmediums (24) für Wasserdampf eingestellt und durch Verringerung der Leckrate kontinuierlich oder in diskreten Schritten erhöht wird.

12. Verfahren nach Anspruch 1 oder 2, **dadurch gekennzeichnet, daß** die relative Feuchtigkeit des Ätzmediums (24) zumindest zeitweise durch Erzeugung von Wasserdampf in der Ätzvorrichtung (10) oder durch Einleitung von Wasserdampf in die Ätzvorrichtung (10) erhöht wird, wobei die eingeleitete oder erzeugte Menge an Wasserdampf schrittweise oder kontinuierlich erhöht wird.

13. Verfahren nach Anspruch 12, **dadurch gekennzeichnet, daß** die Erzeugung des Wasserdampfes zumindest zeitweise durch einen innerhalb der Ätzvorrichtung (10) angeordneten Verdampfer und/oder eine Ultraschalleinstrahlung in das Fluorwasserstoffsäure-Wassergemisch (23) erfolgt, und/oder daß dem Ätzmedium (24) ein über eine Düse erzeugter Wasserdampf zugeführt wird.

14. Verfahren nach Anspruch 12, **dadurch gekennzeichnet, daß** die Temperatur des Wasserdampfes auf eine gleiche oder höhere Temperatur als die Temperatur des Fluorwasserstoffsäure-Wassergemisches (23) eingestellt wird.

15. Verfahren nach Anspruch 1, **dadurch gekennzeichnet, daß** die relative Feuchtigkeit des Ätzmediums (24) zumindest zeitweise über einen in der Ätzvorrichtung (10) vorgesehenen Kondensor erhöht wird, wobei zumindest zeitweise die durch den Kondensor pro Zeiteinheit gebildete Menge an Kondensat kontinuierlich oder schrittweise erniedrigt wird.

16. Verfahren nach Anspruch 1, **dadurch gekennzeichnet, dass** nach Erreichen einer zumindest nahezu vollständigen Entfernung der Opferschicht (2) der Ätzprozeß zumindest weitgehend, insbesondere in möglichst kurzer Zeit, unterbrochen wird, wobei der Ätzprozeß durch eine schrittweise oder kontinuierliche Erniedrigung der relativen Feuchtigkeit in dem Ätzmedium (24) und/oder durch eine schrittweise oder kontinuierliche Erhöhung der Temperatur des Substrates (25) unterbrochen wird.

17. Verfahren nach Anspruch 16, **dadurch gekennzeichnet, daß** der Zeitpunkt des Erreichens der zumindest nahezu vollständigen Entfernung der Opferschicht (2) über eine Meßvorrichtung, insbesondere eine kontinuierlich oder stichpunktartig arbeitende Meßvorrichtung zur Bestimmung einer Unterätzweite, erfaßt wird.

## Claims

1. Process for producing surface micromechanical structures, in which a sacrificial layer (2), which at least largely or in regions comprises silicon dioxide, is deposited on a heatable substrate (25) and patterned, a second layer (3) is deposited on the sacrificial layer (2) and patterned, and the sacrificial layer (2) is removed in an etching process by an etching medium (24) in vapour form which contains hydrofluoric acid, thereby uncovering the surface micromechanical structures (9), **characterized in that** as removal of the sacrificial layer (2) progresses, the relative moisture content of the etching medium (24) is increased in a controlled way, with sacrificial layer residues (8) beneath the structures (9) being at least largely or completely removed.

2. Process according to Claim 1, **characterized in that** the increase in the relative moisture content of the etching medium (24) is carried out taking account of the temperature or the temperature and surface condition of the substrate (25), the increase in the relative moisture content of the etching medium (24) being associated with a change in the hydrofluoric acid concentration and a change in the relative moisture content of the etching medium (24).

3. Process according to Claim 1 or 2, **characterized in that** the increase takes place continuously.

4. Process according to Claim 1 or 2, **characterized in that** the increase takes place in discrete stages.

5. Process according to Claim 1, **characterized in that** the etching medium (24) at least from time to time is produced by evaporation of a substantially azeotropic hydrofluoric acid/water mixture.

6. Process according to Claim 1 or 2, **characterized in that** a gas that is substantially chemically inert with respect to the etching process, in particular nitrogen, oxygen or argon, is added to the etching medium (24), the increase in the relative moisture content and/or the increase in the hydrofluoric acid concentration in the etching medium (24) at least from time to time being effected by a continuous or stepped reduction in the concentration of the chemically inert gas in the etching medium (24).

7. Process according to Claim 1 or 2, **characterized in that** the increase in the relative moisture content at least from time to time is effected by a continuous or stepped reduction in the temperature of the substrate (25).

8. Process according to Claim 1 or 2, **characterized in that** the increase in the relative moisture content at least from time to time is effected by a continuous or stepped increase in the temperature of the hydrofluoric acid/water mixture (23).

9. Process according to Claim 1 or 2, **characterized in that** the increase in the relative moisture content at least from time to time is effected by a continuous or stepped reduction in a preset temperature difference between the substrate (25) and the hydrofluoric acid/water mixture (23).

10. Process according to Claim 1 or 2, **characterized in that** the increase in the relative moisture content at least from time to time is effected by a controlled addition, in particular a continuous or discrete stepwise increase in the addition, of dry HF gas to the etching medium (24).

11. Process according to Claim 1 or 2, **characterized in that** the increase in the relative moisture content at least from time to time is effected by means of a leakage device, via which a proportion of the etching medium (24) is allowed to escape from the etching device (10) with a controllable leak rate, with the relative moisture content of the etching medium (24) which is in vapour form and contains hydrofluoric acid at least from time to time being set by means of the leak rate for water vapour and being increased continuously or in discrete steps by reducing the leak rate.

12. Process according to Claim 1 or 2, **characterized in that** the relative moisture content of the etching medium (24) at least from time to time is increased by generating water vapour in the etching device (10) or by introducing water vapour into the etching device (10), with the quantity of water vapour which is introduced or generated being increased in steps or continuously.

13. Process according to Claim 12, **characterized in that** at least from time to time the generation of the water vapour is effected by an evaporator arranged within the etching device (10) and/or radiation of ultrasound into the hydrofluoric acid/water mixture (23), and/or **in that** a water vapour generated via a nozzle is fed to the etching medium (24).

14. Process according to Claim 12, **characterized in that** the temperature of the water vapour is set to a temperature which is greater than or equal to the temperature of the hydrofluoric acid/water mixture (23).

15. Process according to Claim 1, **characterized in that** the relative moisture content of the etching medium (24) at least from time to time is increased by means of a condenser provided in the etching device (10), in which case at least from time to time the quantity of condensate formed by the condenser per unit time is reduced continuously or in steps.

16. Process according to Claim 1, **characterized in that** after at least virtually complete removal of the sacrificial layer (2) has been achieved, the etching process is at least substantially interrupted, in particular within the shortest possible time, the etching process being interrupted by a stepped or continuous reduction in the relative moisture content in the etching medium (24) and/or by a stepped or continuous increase in the temperature of the substrate (25).

17. Process according to Claim 16, **characterized in that** the instant at which the at least virtually complete removal of the sacrificial layer (2) is achieved is recorded using a measuring device, in particular a measuring device which operates continuously or at sampling points in order to determine an underetch width.

## Revendications

1. Procédé de fabrication de structures micromécaniques superficielles, selon lequel on dépose et on structure sur un substrat à graver (25), une couche sacrificielle (2) composée, au moins dans une large mesure ou localement de dioxyde de silicium, une deuxième couche (3) est précipitée et structurée sur la couche sacrificielle (2) et la couche sacrificielle (2) est éliminée lors d'un processus de gravure par un agent de gravure (24) en phase vapeur contenant de l'acide fluorhydrique, moyennant quoi les structures micromécaniques superficielles (9) sont révélées,
**caractérisé en ce qu'**
au cours de la progression de l'élimination de la couche sacrificielle (2), on produit une augmentation contrôlée de l'humidité relative dans l'agent de gravure (24), ce qui permet d'éliminer au moins largement ou totalement les restes (8) de couche sacrificielle sous les structures (9).

2. Procédé selon la revendication 1,
**caractérisé en ce qu'**
on produit l'augmentation de l'humidité relative de l'agent de gravure (24) en fonction de la température ou de la température et de la structure superficielle du substrat (25), l'augmentation de l'humidité relative de l'agent de gravure (24) étant liée à une modification de la concentration en acide fluorhydrique et à une modification de l'humidité relative de l'agent de gravure (24).

3. Procédé selon la revendication 1 ou 2,
**caractérisé en ce qu'**
on produit l'augmentation en continu.

4. Procédé selon la revendication 1 ou 2,
**caractérisé en ce que**
on produit l'augmentation par étapes discrètes.

5. Procédé selon la revendication 1,
**caractérisé en ce que**
l'agent de gravure (24) est produit, au moins temporairement, par vaporisation d'un mélange d'eau et d'acide fluorhydrique essentiellement azéotrope.

6. Procédé selon la revendication 1 ou 2,
**caractérisé en ce qu'**
un gaz essentiellement chimiquement inerte pour le processus de gravure, notamment l'azote, l'oxygène ou l'argon, est ajouté à l'agent de gravure (24), l'augmentation de l'humidité relative et/ou l'augmentation de la concentration en acide fluorhydrique de l'agent de gravure (24) étant produite au moins temporairement par réduction en continu ou graduelle de la concentration en gaz chimiquement inerte de l'agent de gravure (24).

7. Procédé selon la revendication 1 ou 2,
**caractérisé en ce que**
l'augmentation de l'humidité relative est produite au moins temporairement par abaissement en continu ou graduel de la température du substrat (25).

8. Procédé selon la revendication 1 ou 2,
**caractérisé en ce que**
l'augmentation de l'humidité relative est produite au moins temporairement par augmentation en continu ou graduelle de la température du mélange (23) d'eau et d'acide fluorhydrique.

9. Procédé selon la revendication 1 ou 2,
**caractérisé en ce que**
l'augmentation de l'humidité relative est produite au moins temporairement par abaissement en continu ou graduel d'une différence thermique pré-réglée entre le substrat (25) et le mélange (23) d'eau et d'acide fluorhydrique.

10. Procédé selon la revendication 1 ou 2,
**caractérisé en ce que**
l'augmentation de l'humidité relative est produite au moins temporairement par ajout contrôlé de HF gazeux sec à l'agent de gravure (24), notamment une augmentation de l'ajout en continu ou par étapes discrètes.

11. Procédé selon la revendication 1 ou 2,
**caractérisé en ce que**
l'augmentation de l'humidité relative est produite au moins temporairement au moyen d'un dispositif de fuite permettant à une partie de l'agent de gravure (24) de s'échapper du dispositif de gravure (10) avec un taux de fuite contrôlable, l'humidité relative de l'agent de gravure (24) en phase vapeur contenant de l'acide fluorhydrique étant réglée, au moins temporairement, par le taux de fuite pour la vapeur d'eau en étant augmentée en continu ou par étapes discrètes par une réduction du taux de fuite.

12. Procédé selon la revendication 1 ou 2,
**caractérisé en ce qu'**
on relève l'humidité relative de l'agent de gravure (24) au moins temporairement par production de vapeur d'eau dans le dispositif de gravure (10) ou par introduction de vapeur d'eau dans le dispositif de gravure (10), la quantité de vapeur d'eau introduite ou produite étant élevée graduellement ou de manière continue.

13. Procédé selon la revendication 12,
**caractérisé en ce qu'**
on produit vapeur d'eau au moins temporairement au moyen d'un évaporateur installé dans le dispositif de gravure (10) et/ou d'un générateur d'ultrasons dans le mélange (23) d'eau et d'acide fluorhydrique, et/ou on apporte de la vapeur d'eau produite par une buse à l'agent de gravure (24).

14. Procédé selon la revendication 12,
**caractérisé en ce que**
la température de la vapeur d'eau est réglée à une température égale ou supérieure à la température du mélange (23) d'eau et d'acide fluorhydrique.

15. Procédé selon la revendication 1,
**caractérisé en ce qu'**
on augmente l'humidité relative de l'agent de gravure (24) au moins temporairement au moyen d'un condenseur prévu dans le dispositif de gravure (10), la quantité de condensat formée par le condenseur par unité de temps étant abaissée au moins temporairement de manière continue ou graduelle.

16. Procédé selon la revendication 1,
**caractérisé en ce que**
après une élimination au moins pratiquement totale de la couche sacrificielle (2), le processus de gravure est au moins largement interrompu, notamment en un temps aussi bref que possible, le processus de gravure étant interrompu par un abaissement graduel ou continu de l'humidité relative de l'agent de gravure (24) et/ou par une augmentation graduelle ou continue de la température du substrat (25).

17. Procédé selon la revendication 16,
**caractérisé en ce que**
l'instant de l'élimination au moins pratiquement totale de la couche sacrificielle (2) est saisi par un dispositif de mesure, notamment un dispositif de mesure à fonctionnement continu ou par échantillonnage pour estimer une largeur de sous-gravure.
